# EUROPEAN PATENT APPLICATION

(11) **EP 2 309 835 A2**
(43) Date of publication of application: **13.04.2011**
(21) Application number: 10013433.7
(22) Date of filing: 07.10.2010
(51) Int. Cl.: H05K 13/04, H05K 13/08

(54) **A method of managing board assembling line and a managing system for board assembling line**

(30) Priority: 09.10.2009 JP 2009235796
(71) Applicant: Hitachi High-Tech Instruments Company, Ltd., Saitama 360-0238 (JP)
(72) Inventor: Wada, Toshiaki, Ora-gun, Gunma (JP); Uchida, Kiyoto, Ota-shi, Gunma (JP); Asai, Jun, Ota-shi, Gunma (JP); Iida, Shigeru, Ota-shi, Gunma (JP)
(74) Representative: Glawe, Delfs, Moll

(57) **Abstract**

Even when there is a plurality of work apparatuses in a board assembling line, the invention decreases manager's work by enabling the manager to change the setups of the plurality of work apparatuses simultaneously corresponding to a board type change. In the state where the second electronic component mounting apparatus (1) from the left is stopped, on a screen displayed on a display device (3), the manager presses a line switch (4A), then presses a type selection switch (4B) to select a type name of Prgm2 in the second row from the top in order to select the type of printed boards to be produced next after the type of printed boards having a type name of Prgm0 that is previously selected and completed to be produced, and then presses a setup change switch (4D) or (4E). By this pressing operation, the microcomputer (2) of this second electronic component mounting apparatus (1) from the left transmits the name of the selected printed board type and a setup change command to all the other electronic component mounting apparatuses (1) than this electronic component mounting apparatus (1) in the board assembling line.

## Description

### BACKGROUND OF THE INVENTION

### Field of the Invention

The invention relates to a method of managing a board assembling line in which a printed circuit board is assembled by mounting electronic components thereon. In detail, the invention relates to a method of managing a board assembling line including an electronic component mounting apparatus that picks up an electronic component from a component feeding device by a suction nozzle and mounts this electronic component on a board, and so on.

An electronic component mounting apparatus of this type forming a board assembling line is disclosed in the Japanese patent application publication No. 2005-159209 and so on, for example. When a work apparatus forming a board assembling line completes a work of assembling one type of printed circuit boards, or when this board assembling line is stopped, i.e., all the apparatuses in the board assembling line are stopped just after holidays during which the factory of the board assembling line is stopped, the manager makes a setup change of this apparatus so as to start a work of assembling the next type of printed circuit boards.

However, when there is a plurality of work apparatuses in the board assembling line, it is very troublesome for the manager to make a setup change of each of the work apparatuses separately so as to start the work of assembling the next type of printed circuit boards since the manager need walk around the work apparatuses so as to make the setup changes of these.

### SUMMARY OF THE INVENTION

Therefore, even when there is a plurality of work apparatuses in a board assembling line, the invention is directed to decreasing manager's work by enabling the manager to make setup changes of the plurality of work apparatuses simultaneously as the type of printed circuit boards to be produced is changed.

The invention resides in the features of the independent claims and preferably in those of the dependent claims.

The invention provides a method of managing a board assembling line including a plurality of work apparatuses each including a work component necessary for a work of mounting electronic components on a board, the board assembling line assembling a board by mounting electronic components thereon using the work apparatuses, the method including transmitting a command to make a setup change of the work component from command means mounted on specified one of the plurality of work apparatuses to the other work apparatuses.

The invention also provides a managing system for a board assembling line including a plurality of work apparatuses each including a work component necessary for a work of mounting electronic components on a printed board, the board assembling line assembling a board by mounting electronic components thereon using the work apparatuses, wherein the plurality of work apparatuses are connected by a network, each comprising command means such that a command to make a setup change of the work component is transmitted from the command means of specified one of the plurality of work apparatuses to the other work apparatuses.

### BRIEF DESCRIPTION OF THE DRAWINGS

Fig. 1 is a schematic view of a board assembling line.
Fig. 2 is a table showing line registered apparatus list data.
Fig. 3 shows a screen for a type change of a printed board and so on.
Fig. 4 is a flow chart for a type change on a transmitter side.
Fig. 5 is a flow chart for a line setup change on the transmitter side.
Fig. 6 is a flow chart for a type change on a receiver side.
Fig. 7 is a flow chart for a line setup change on the receiver side.

### DETAILED DESCRIPTION OF THE INVENTION

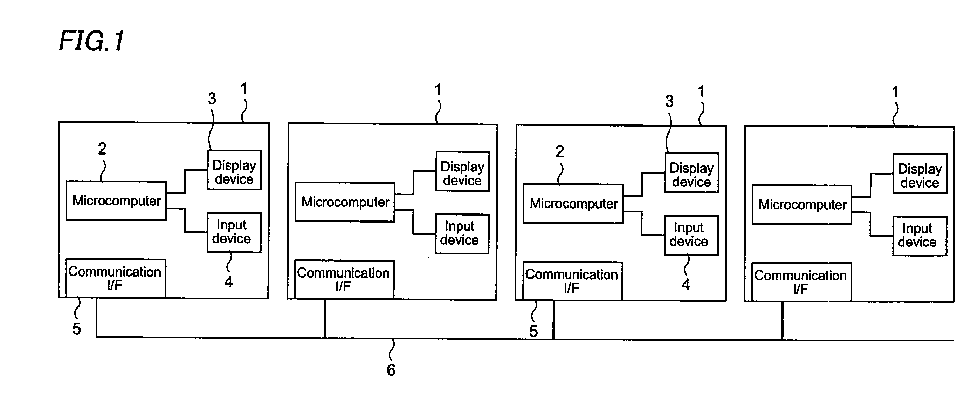

An embodiment of the invention will be described hereafter. First, a structure of a management system of a printed circuit board production line will be described referring to Fig. 1. This production line is a board assembling line for assembling a printed circuit board in a factory. Each of work apparatuses forming this board assembling line includes a screen printing apparatus that coats solder paste on a printed board, an adhesive coating apparatus that coats an adhesive on a printed board, an electronic component mounting apparatus that picks up an electronic component from a component feeding unit by a suction nozzle mounted on a mounting head and mounts the electronic component on a printed board, and so on. For simplicity, however, the following description will use only four electronic component mounting apparatuses 1 as the work apparatuses of which the controls of the mounting operations are manageable in the board assembling line. However, the invention is not limited to these electronic component mounting apparatuses 1. The invention is also applicable to other screen printing apparatus and other adhesive coating apparatus, and further applicable to all work apparatuses that form a board assembling line.

Multiple component feeding units in each of the electronic component mounting apparatuses 1 are detachably arrayed on the feeder bases of a cart as a fixation mount, and the cart is detachably set on the body of the electronic component mounting apparatus 1. The component feeding units are set thereon so that the end portions on their component feeding sides are positioned in a mounting head pickup region (component pickup region). The component feeding unit has a tape forwarding system that intermittently forwards a storage tape to an electronic component pickup position by a forwarding motor by turning a forwarding sprocket by a given angle, the teeth of the forwarding sprocket being engaged with forwarding holes formed at given intervals in the storage tape sequentially forwarded from a feed reel on which the storage tape is wound, the feed reel being rotatably set on the cart. The component feeding unit also has a cover tape peeling system that peels a cover tape from a carrier tape that is part of the storage tape in a position before the component pickup position by a peeling motor. The cover tape is peeled by the cover tape peeling system, and electronic components stored in storage portions formed in the carrier tape at given intervals are sequentially fed to the component pickup position and picked up from the end portion by suction nozzles as pickup means.

The mounting head is movable in the horizontal, vertical and rotational directions, and a plurality of suction nozzles is mounted on this mounting head, being vertically movable.

Each of the electronic component mounting apparatuses 1 has a microcomputer 2 as control means of controlling operations relating to the component mounting operation for mounting electronic components on a printed board and also as command means of commanding a setup change that will be described below. This microcomputer 2 is connected to a display device 3 such as a monitor and an input device 4 including touch panel switches displayed on the monitor, for example, through a LAN 6. Each of the microcomputers 2 is connected to a communication interface 5, and data such as various types of commands are transmittable and receivable between the microcomputers 2 through the communication interfaces 5 and the LAN 6.

The microcomputer 2 includes a CPU (central processing unit) as control means, a ROM (read only memory) storing programs, and a RAM (random access memory) as memory means. The CPU controls operations relating to the component mounting operation based on the data stored in the RAM and according to the programs stored in the ROM.

The RAM of the microcomputer 2 of each of the electronic component mounting apparatuses 1 stores pattern program data for the operation of the electronic component mounting apparatuses 1 for each of the types of printed boards to be produced, and this pattern program data is given a type name common to all the apparatuses. This pattern program data includes board data including the sizes of printed boards in the X and Y directions, the thicknesses, the possession or non-possession of board recognition marks, etc, mounting data indicating the mounting coordinates of each of electronic components on a printed board in mounting order, component disposition data about the type of each of electronic components corresponding to the disposition number of each of the component feeding units, suction nozzle disposition data indicating the positions on the mounting head and the types of suction nozzles mounted in these positions, and so on.

Although the electronic component mounting apparatuses 1 store the pattern program data given a common name to these electronic component mounting apparatuses 1 as described above, each of the electronic component mounting apparatuses 1 stores only a part of the data for itself to perform the mounting operation. However, each of the electronic component mounting apparatuses 1 may store the whole data about the type of a printed board instead of a part of the data for itself, and in this case each of the apparatuses recognizes its part. When the pattern program data for the same type differs between the apparatuses, the suction nozzle disposition data may differ between the apparatuses corresponding to the corresponding mounting data and thus each of the apparatuses stores the data for itself for each of the type names. When each of the apparatuses stores the whole pattern program data, each of the apparatuses recognizes its part of the suction nozzle disposition data.

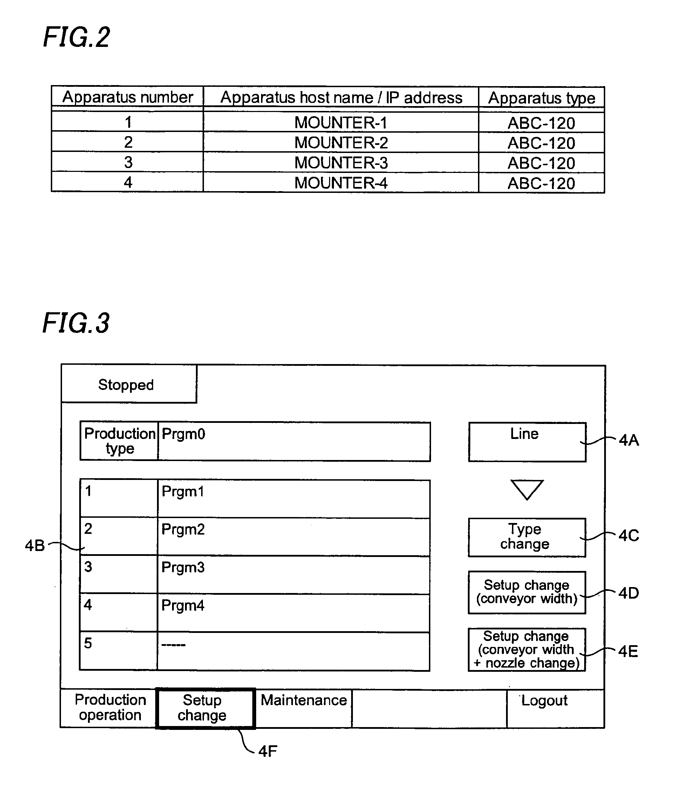

Furthermore, the RAM stores component library data about the features of electronic components, line registered apparatus list data and so on. The line registered apparatus list data includes the apparatus numbers, apparatus host names (IP addresses) and apparatus types (models) of the electronic component mounting apparatuses 1 as shown in Fig. 2.

Furthermore, the RAM stores the structure of the apparatuses of which the controls of the mounting operations are manageable in the board assembling line, in disposition order in the board assembling line.

Furthermore, the RAM stores production type data including data about suction nozzles for use on each of the mounting heads provided corresponding to necessary data obtained from the pattern program data and data about the conveyor width of the carrying device carrying a printed board, for each of the types of printed boards and for each of the apparatuses forming the board assembling line. These suction nozzles, carrying device and so on are work components for the work of mounting electronic components on a printed board.

It is noted that these production type data and pattern program data for each of the types of printed boards are transmitted from an offline computer (not shown) to each of the electronic component mounting apparatuses 1 and stored in the microcomputer 2 of each of the electronic component mounting apparatuses 1. However, the production type data may be formed from the pattern program data in each of the apparatuses 1 instead.

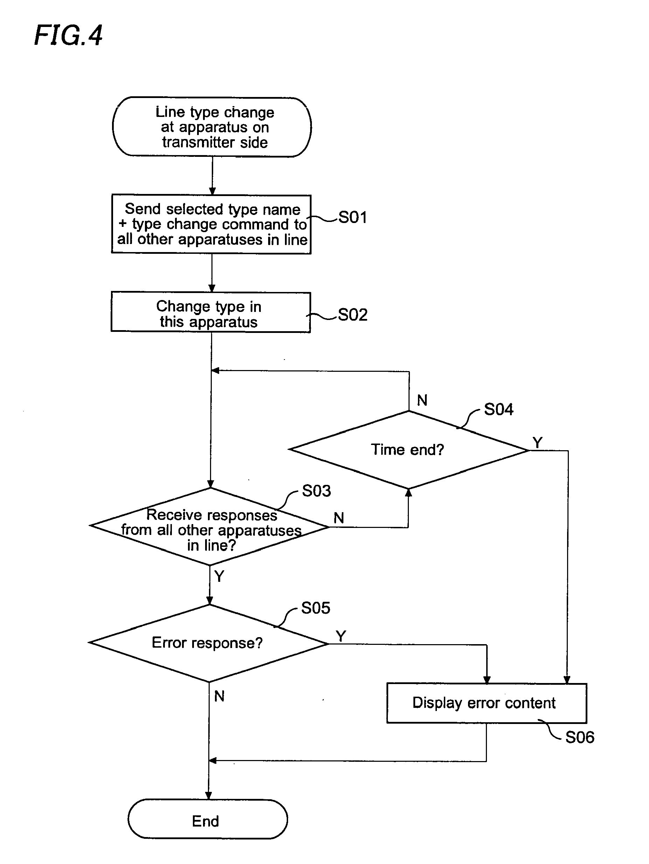

A flow chart for a line type change on a transmitter side in Fig. 4 will be described first. A description will be given on an operation of changing the type of printed boards by operating the input device 4 on a screen shown in Fig. 3 displayed on the display device 3 at the second electronic component mounting apparatus 1 from the upstream side near the manager (the second apparatus from the left in Fig. 1 since a printed board is carried from the left to the right), for example.

In the state where the second electronic component mounting apparatus 1 from the left is stopped (it means the state where the apparatus is not sending a request for a printed board to the upstream side and is stopped, and also means the same hereafter), the manager presses a setup change switch 4F displayed on the display device 3 of this electronic component mounting apparatus 1 so as to display the screen shown in Fig. 3 on the display device 3, and presses a line switch 4A. The manager then presses a type selection switch 4B to select the type name of Prgm2 in the second row from the top so as to select the type of printed boards to be produced next after the type of printed boards having the type name of Prgm0 that is previously selected and completed to be produced, and presses a type change switch 4C.

By this type change operation, the microcomputer 2 of this second electronic component mounting apparatus 1 from the left transmits the name of the selected printed board type and a type change command to make a type change to all the other electronic component mounting apparatuses 1 than this electronic component mounting apparatus 1 in the board assembling line (step S01). Then the microcomputer 2 of this second electronic component mounting apparatus 1 from the left controls itself to make the type change (step S02). In detail, the microcomputer 2 stores the type name of Prgm2 as the next type of printed boards to be produced in its RAM.

Then the microcomputer 2 judges whether or not it receives responses to the contents which the microcomputer 2 transmits as described above from all the other electronic component mounting apparatuses 1 than this electronic component mounting apparatus 1 in the board assembling line (step S03), and this judgment is repeated until a timer (not shown) counts a predetermined time (step S04).

When there is at least one error response in the responses which the microcomputer 2 receives from the other electronic component mounting apparatuses 1 than this electronic component mounting apparatus 1 in the board assembling line before the timer counts the predetermined time (step S05), or when the microcomputer 2 does not receive responses from all the other electronic component mounting apparatuses 1 when the timer counts the predetermined time, the microcomputer 2 controls the display device 3 of this electronic component mounting apparatus 1 to display the error content thereon (step S06). By this, the manager can recognize that there is one in an error state among the electronic component mounting apparatuses 1 except this electronic component mounting apparatus 1, and perform a work to be performed then.

When there is no error response in all the responses which the microcomputer 2 receives from all the other electronic component mounting apparatuses 1 than this electronic component mounting apparatus 1 before the timer counts the predetermined time, the computer 2 judges the apparatuses to be normal and ends. This means that the name of the selected printed board type and the type change command are transmitted to all the other electronic component mounting apparatuses 1 than this electronic component mounting apparatus 1 in the board assembling line.

The line type change operation on the transmitter side is thus performed.

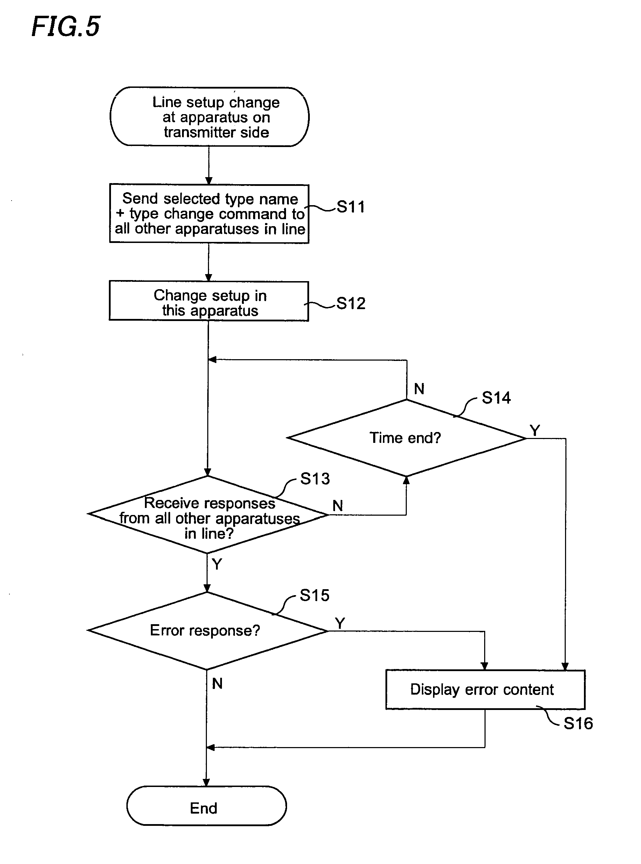

Next, a flow chart for a line setup change on the transmitter side in Fig. 5 will be described. A description will be given on a line setup change by operating the input device 4 on the screen shown in Fig. 3 displayed on the display device 3 at the second electronic component mounting apparatus 1 from the left near the manager, for example.

In the state where the second electronic component mounting apparatus 1 from the left is stopped, the manager operates the input device 4 of this electronic component mounting apparatus 1 so as to display the screen shown in Fig. 3 on the display device 3, and presses the line switch 4A to control the apparatuses in the board assembling line simultaneously instead of separately. The manager then presses the type selection switch 4B to select the type name of Prgm2 in the second row from the top so as to select the type of printed boards to be produced next after the type of printed boards having the type name of Prgm0 that is previously selected and completed to be produced, and presses a setup change switch 4D or 4E. The line switch 4A changes its color when pressed, and the setup of the board assembling line is performed thereafter.

In this case, the setup change switch 4D is a switch for a type change and a setup change of the width of the conveyor as the work component that carries a printed board, and the setup change switch 4E is a switch for a type change and a setup change of the width of the conveyor and the suction nozzles as the work components.

When the type selection switch and the setup change switch 4D or 4E are pressed in the state where the line switch 4A is not pressed, the setup change is made to only the apparatus having the operated input device. Furthermore, when the line switch 4A is pressed again after the line switch 4A is pressed, the color of the line switch 4A turns back to the color before pressed and the setup of the board assembling line is cancelled and turned back into the setup change mode only for the operated apparatus.

Then when the setup change switch 4D or 4E mentioned above is pressed, the microcomputer 2 of the second electronic component mounting apparatus 1 from the left transmits the name of the selected printed board type and a setup change command to make a type change and a setup change to all the other electronic component mounting apparatuses 1 than this electronic component mounting apparatus 1 in the board assembling line (step S11). In detail, when the setup change switch 4D is pressed, a command to make a type change and a setup change of the conveyor width is transmitted. When the setup change switch 4E is pressed, a command to make a type change and a setup change of the conveyor width and the suction nozzles is transmitted.

Then the microcomputer 2 of this second electronic component mounting apparatus 1 from the left controls itself to make a setup change of this second electronic component mounting apparatus 1 (step S12). In detail, the type name of Prgm2 as the next printed boards to be produced is stored in the RAM of the microcomputer 2, and a setup change work is automatically performed. In this case, when the setup change switch 4D is pressed, a setup change of the conveyor width is made. When the setup change switch 4E is pressed, a setup change of the conveyor width and suction nozzles is made.

Then the microcomputer 2 judges whether or not it receives responses to the contents which the microcomputer 2 transmits as described above from all the other electronic component mounting apparatuses 1 than this electronic component mounting apparatus 1 in the board assembling line (step S13), and this judgment is repeated until the timer (not shown) counts a predetermined time (step S14).

When there is at least one error response in the responses which the microcomputer 2 receives from the other electronic component mounting apparatuses 1 than this electronic component mounting apparatus 1 in the board assembling line before the timer counts the predetermined time (step S15), or when the microcomputer 2 does not receive responses from all the other electronic component mounting apparatuses 1 when the timer counts the predetermined time, the microcomputer 2 controls the display device 3 of this electronic component mounting apparatus 1 to display the error content thereon (step S16). By this, the manager can recognize that there is one in an error state among the electronic component mounting apparatuses 1 except this electronic component mounting apparatus 1, and perform a work to be performed then.

When there is no error response in all the responses which the microcomputer 2 receives from all the other electronic component mounting apparatuses 1 than this electronic component mounting apparatus 1 before the timer counts the predetermined time, the microcomputer 2 judges the apparatuses to be normal and ends. This means that the name of the selected printed board type and the setup change command are transmitted to all the other electronic component mounting apparatuses 1 than this electronic component mounting apparatus 1 in the board assembling line.

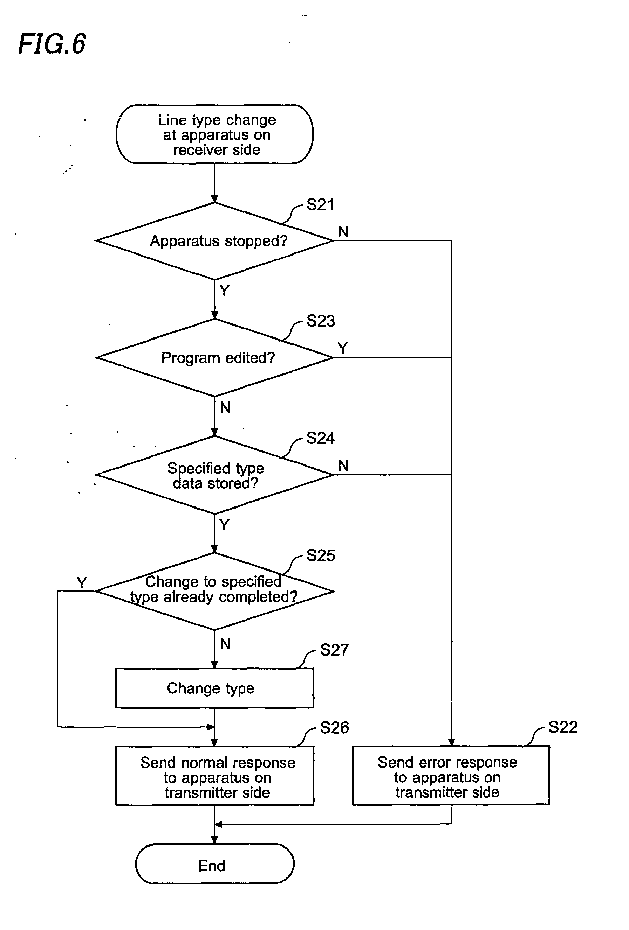

Next, a flow chart for a line type change on a receiver side in Fig. 6 will be described. First, a description will be given using the leftmost electronic component mounting apparatus 1 on the receiver side as an example. When the leftmost electronic component mounting apparatus 1 receives the type name and the type change command transmitted from the second electronic component mounting apparatus 1 from the left as described above, the microcomputer 2 of the leftmost electronic component mounting apparatus 1 first judges whether or not this leftmost electronic component mounting apparatus 1 is stopped (step S21). When this electronic component mounting apparatus 1 is judged not to be stopped, i.e., in operation, the microcomputer 2 makes an error response to the second electronic component mounting apparatus 1 from the left on the transmitter side (step S22). In other words, the type change of printed boards is not made when the apparatus 1 is in operation.

When the microcomputer 2 judges that this apparatus 1 is stopped, the microcomputer 2 then judges whether or not this apparatus 1 is editing the pattern program (step S23). When the apparatus 1 is editing the pattern program, the microcomputer makes an error response to the second electronic component mounting apparatus 1 from the left on the transmitter side (step S22). In other words, the type change of printed boards is not made when the apparatus 1 is editing the pattern program.

When the microcomputer 2 judges that this electronic component mounting apparatus 1 is stopped and not editing the pattern program, the microcomputer 2 then judges whether or not pattern program data about the specified production type exists in the microcomputer 2 of this electronic component mounting apparatus 1 (step S24). In detail, the microcomputer 2 judges whether or not the pattern program data about the specified type of printed boards (having the type name of Prgm2) exists therein. When this pattern program data does not exist therein, the microcomputer 2 makes an error response to the second electronic component mounting apparatus 1 from the left on the transmitter side (step S22). In other words, the type change of printed boards is not made when the pattern program data does not exist in the microcomputer 2 (is not stored in the RAM).

When the pattern program data exists in the microcomputer 2, the microcomputer 2 then judges whether or not the change to the specified type is already completed (step S25). When the change is already completed, the microcomputer 2 makes a normal response to the second electronic component mounting apparatus 1 from the left on the transmitter side (step S26).

When the change is not completed yet, this leftmost electronic component mounting apparatus 1 makes the type change (step S27), makes a normal response to the second electronic component mounting apparatus 1 from the left on the transmitter side (step S26), and ends.

Although the above description is given using the leftmost electronic component mounting apparatus 1 as an example of one of the electronic component mounting apparatuses 1 on the receiver side, the same control is performed to the other electronic component mounting apparatuses 1.

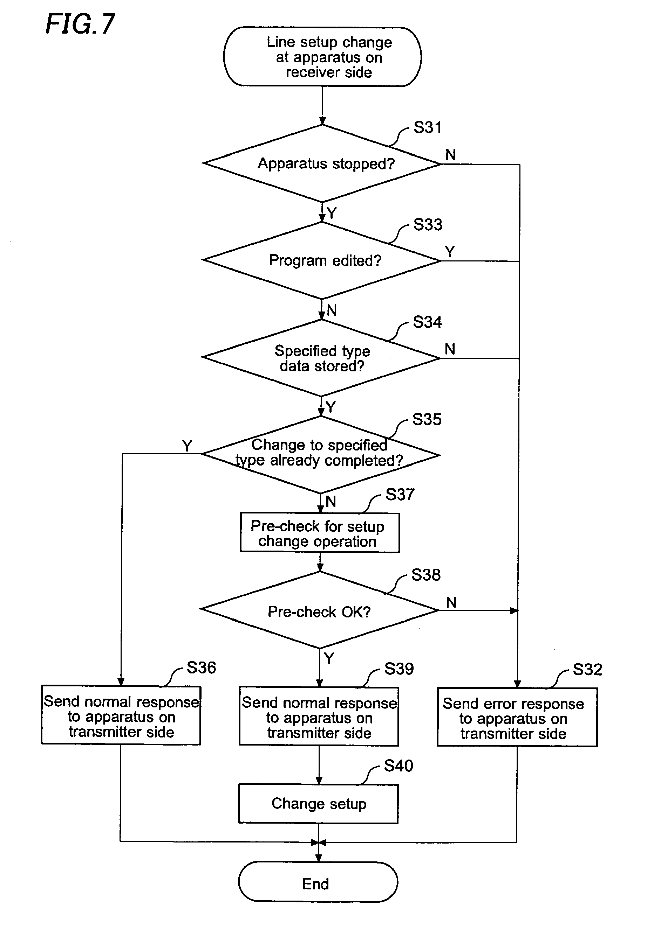

Next, a flow chart for a line setup change on the receiver side in Fig. 7 will be described. First, a description will be given using the leftmost electronic component mounting apparatus 1 on the receiver side as an example. When the leftmost electronic component mounting apparatus 1 receives the type name and the setup change command transmitted from the second electronic component mounting apparatus 1 from the left as described above, the microcomputer 2 of the leftmost electronic component mounting apparatus 1 first judges whether or not this leftmost electronic component mounting apparatus 1 is stopped (step S31). When this electronic component mounting apparatus 1 is judged not to be stopped, i.e., in operation, the microcomputer 2 makes an error response to the second electronic component mounting apparatus 1 from the left on the transmitter side (step S32). In other words, the setup change of the work components corresponding to the type change of printed boards is not made when the apparatus 1 is in operation.

When the microcomputer 2 judges that this apparatus 1 is stopped, the microcomputer 2 then judges whether or not this apparatus 1 is editing the pattern program (step S33). When the apparatus 1 is editing the pattern program, the microcomputer makes an error response to the second electronic component mounting apparatus 1 from the left on the transmitter side (step S32). In other words, the setup change of the work components corresponding to the type change of printed boards is not made when the apparatus 1 is editing the pattern program.

When the microcomputer 2 judges that this electronic component mounting apparatus 1 is stopped and not editing the pattern program, the microcomputer 2 then judges whether or not the pattern program data about the specified production type exists in the microcomputer 2 of this electronic component mounting apparatus 1 (step S34). In detail, the microcomputer 2 judges whether or not the pattern program data about the specified type of printed boards (having the type name of Prgm2) exists therein. When this pattern program data does not exist therein, the microcomputer 2 makes an error response to the second electronic component mounting apparatus 1 from the left on the transmitter side (step S32). In other words, the setup change of the work components corresponding to the type change of printed boards is not made when the pattern program data does not exist in the microcomputer 2 (is not stored in the RAM).

When the pattern program data exists in the microcomputer 2, the microcomputer 2 then judges whether or not the setup change to the specified type is already completed (step S35). When the change is already completed, the microcomputer 2 makes a normal response to the second electronic component mounting apparatus 1 from the left on the transmitter side (step S36).

When the change is not completed yet, this leftmost electronic component mounting apparatus 1 makes a pre-check on itself for the setup change operation (step S37). The microcomputer 2 judges whether or not the result of this pre-check is OK (step S38). When this pre-check result is not OK, the microcomputer 2 makes an error response to the second electronic component mounting apparatus 1 from the left on the transmitter side (step S32). In other words, the setup change of the work components corresponding to the type change of printed boards is not made when the pre-check result is not OK, for example, when a suction nozzle to be mounted on the mounting head this time is not stored in the nozzle stocker.

When the pre-check result is OK, the microcomputer 2 makes a normal response to the second electronic component mounting apparatus 1 from the left on the transmitter side (step S39), then makes the necessary setup change (step S40), and ends.

In this case, the content of the received setup change command differs depending on whether the setup change switch 4D is pressed or the setup change switch 4E is pressed, and the microcomputer 2 that receives this command controls the setup change corresponding to the command. In detail, when the setup change switch 4D is pressed, corresponding to the setup change command transmitted this time, the setup change of the conveyor width is made based on the production type data obtained from the pattern program data of this apparatus 1. When the setup change switch 4E is pressed, corresponding to the setup change command transmitted this time, the setup change of the conveyor width and the suction nozzles is made based on the production type data obtained from the pattern program data of this apparatus 1.

Although the above description is given using the leftmost electronic component mounting apparatus 1 as an example of one of the electronic component mounting apparatuses 1 on the receiver side, the same control is performed to the other electronic component mounting apparatuses 1.

Even when there is the plurality of work apparatuses in the board assembling line, the manager's work is decreased by enabling the manager to transmit a command from any one of the work apparatuses to the other work apparatuses so as to make setup changes corresponding to the type change of printed boards. Furthermore, the manager's work is decreased since the setup changes of the plurality of work apparatuses are made simultaneously.

Furthermore, the invention is not limited to the case of enabling the manager to transmit a command from any one of the work apparatuses forming the board assembling line to the other work apparatuses so as to make setup changes corresponding to the type change of printed boards, the other work apparatuses being manageable in mounting operation control in the board assembling line. The invention is also applicable to a case of enabling the manager to transmit a command only from specified one of the work apparatuses to the other manageable work apparatuses so as to make setup changes. Furthermore, the invention is also applicable to a case of enabling the manager to transmit a command from an external managing computer that does not form the board assembling line to all the manageable work apparatuses so as to make setup changes, instead of from one of the work apparatuses forming the board assembling line. These cases also decrease the manager's work since the setup changes of the plurality of work apparatuses are made simultaneously.

The embodiment of the invention is described above. It is recognized that variations or modifications of the disclosed method are possible based on the disclosure for those skilled in the art and lie within the scope of the invention.

Even when there is a plurality of work apparatuses in a board assembling line, the invention decreases manager's work by enabling the manager to make setup changes of the plurality of work apparatuses simultaneously corresponding to the type change of printed boards.

## Claims

1. A method of managing a board assembling line comprising a plurality of work apparatuses (1) each comprising a work component necessary for a work of mounting electronic components on a board, the board assembling line assembling a board by mounting electronic components thereon using the work apparatuses (1), **characterized by** transmitting a command to make a setup change of the work component from a command means mounted on specified one of the plurality of work apparatuses (1) to the other work apparatuses (1).

2. The method according to claim 1, **characterized in that** the command to make the setup change of the work component is transmittable from any one of the plurality of work apparatuses (1) to the other work apparatuses (1).

3. The method according to claim 1 or 2, **characterized by** transmitting the command to make the setup change of the work component from a managing computer provided outside the plurality of work apparatuses (1) to each of the work apparatuses (1).

4. The method according to any of claims 1 to 3, **characterized in that** the setup change of the work component is to change a width of a conveyor that carries the board or to change a suction nozzle that picks up the electronic component.

5. A managing system for a board assembling line comprising a plurality of work apparatuses (1) each comprising a work component necessary for a work of mounting electronic components on a board, the board assembling line assembling the board by mounting electronic components thereon using the work apparatuses (1), **characterized in that** the plurality of work apparatuses (1) are connected by a network (6), each comprising command means (2) such that a command to make a setup change of the work component is transmitted from the command means (2) of specified one of the plurality of work apparatuses (1) to the other work apparatuses (1).

6. The managing system according to claim 5, **characterized in that** the command to make the setup change of the work component is transmittable from any one of the plurality of work apparatuses (1) to the other work apparatuses (1).

7. The managing system according to claim 5 or 6, **characterized by** a managing computer provided outside the plurality of work apparatuses (1) and transmitting the command to make the setup change of the work component to each of the work apparatuses (1).

8. The managing system according to any of claims 5 to 7, **characterized in that** the setup change of the work component is to change a width of a conveyor that carries the printed board or to change a suction nozzle that picks up the electronic component.

9. The managing system according to any of claims 5 to 8, **characterized in that** each of the plurality of work apparatuses (1) further comprises a microcomputer (2) and an interface (5) for connection to the network (6) such that the command is transmittable and receivable between the microcomputers (2).

10. The managing system according to any of claims 5 to 9, **characterized in that** the microcomputer (2) comprises a CPU and a memory, the memory storing a pattern program data for operating the work apparatus (1) and a data for changing the width of the conveyor or a data for changing the suction nozzle.
